# EUROPEAN PATENT APPLICATION

(11) **EP 4 836 303 A1**
(43) Date of publication of application: **04.11.2026**
(21) Application number: 26169115.8
(22) Date of filing: 30.03.2026
(51) Int. Cl.: H03L 7/093, H03L 7/099

(54) **SINGLE CHARGE-PUMP DUAL PATH PLL**

(30) Priority: 30.04.2025 IN 202541041587
(71) Applicant: NXP USA, Inc, Austin, TX 78735 (US)
(72) Inventor: Bugade, Vishwajit Babasaheb, 5656 AG Eindhoven (NL); Sinha, Anand Kumar, 5656 AG Eindhoven (NL); Omer, Ateet, 5656 AG Eindhoven (NL); Dutta, Ramen, 5656 AG Eindhoven (NL)
(74) Representative: Schmütz, Christian Klaus Johannes

(57) **Abstract**

A single charge-pump dual path PLL method, system, and apparatus are provided with a phase-frequency detector, single charge pump, loop filter, dual path voltage-to-current converter circuit, current controlled ring oscillator, and feedback clock divider, where the dual path voltage-to-current converter circuit is connected to receive a voltage control signal (V_{CTL}) and integral voltage control signal (V_{CTLi}) from the loop filter, and is configured with two separate paths having separate gains to generate a proportional control current and an integral control current that are combined to generate a ring oscillator control signal.

## Description

### BACKGROUND OF THE INVENTION

### Field of the Invention

The present disclosure is directed in general to electronic circuits. In one aspect, the present invention relates to phase locked loop circuits.

### Description of the Related Art

The design and operation of high-speed data transfer networks rely on the accurate generation of precise clock signals, which is a critical requirement for efficient and reliable data transmission. In conventional phase lock loop (PLL) circuits, achieving both low peaking and low closed-loop bandwidth is a challenging task due to the inherent trade-offs between these two performance metrics. In traditional single-path charge-pump PLL architectures, bandwidth and frequency peaking are inextricably linked, making it difficult to optimize one without compromising the other. This limitation stems from the fact that conventional single-path PLLs suffer from a correlation between bandwidth and peaking, where low peaking is typically accompanied by high bandwidth and vice versa.

As a result of this fundamental challenge, designers have resorted to employing dual-path PLL circuits, which offer a compromise between low peaking and low closed-loop bandwidth. By separating the control voltage into two distinct paths - proportional and integral - dual-path PLLs can achieve both goals. However, despite their performance benefits, dual-path PLL circuits are not without their drawbacks. One of the primary challenges associated with dual-path PLLs is the occurrence of phase offset mismatch between the charge pumps, which causes ripples in the proportional control voltage. These ripples can lead to significant jitter in the output clock signal, resulting in high reference spur issues that can be detrimental to system performance.

Another issue that arises in dual-path PLL circuits is the need for proper DC biasing of the proportional control voltage. Unlike single-path PLLs, where DC biasing is often regulated through negative feedback, dual-path PLLs require an independent means of biasing the proportional control voltage. This adds complexity and expense to the design process, as designers must carefully manage the biasing circuitry to achieve optimal performance. Existing solutions for addressing these challenges have been proposed, but they often rely on sophisticated design techniques that can be difficult to implement in practice.

The limitations of conventional dual-path PLL architectures have significant implications for the design and operation of high-speed data transfer networks. The need for complex and expensive circuitry to address issues related to offset mismatch and DC biasing can drive up system costs and increase development time. Furthermore, the potential for jitter and reference spur issues can compromise system reliability and performance. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.
Figure 1 illustrates a high-level block diagram of a conventional single path charge pump phase locked loop (PLL) circuit.
Figure 2 illustrates a high-level block diagram of a conventional dual path charge pump PLL circuit.
Figure 3 illustrates a high-level block diagram of a single charge pump, dual path PLL circuit with a voltage converter and dual path voltage-controlled oscillators in accordance with selected embodiments of the present disclosure.
Figure 4 illustrates a high-level block diagram of a single charge pump, dual path PLL circuit with a voltage-to-current converter and shared charge control oscillator in accordance with selected embodiments of the present disclosure.
Figure 5 depicts a circuit schematic diagram of a voltage-to-current converter and shared charge control oscillator in accordance with selected embodiments of the present disclosure.
Figure 6 depicts a circuit schematic diagram of a voltage-to-current converter and shared charge control oscillator in accordance with selected embodiments of the present disclosure.
Figure 7 depicts a simulated plot of the closed-loop transfer function of the single charge pump dual path PLL circuit in accordance with selected embodiments of the present disclosure.
Figure 8 depicts a simulated plot of the loop gain of the single charge pump dual path PLL circuit in accordance with selected embodiments of the present disclosure.
Figure 9 depicts a simplified flowchart diagram showing the logic for controlling the operation of a single charge pump dual path PLL circuit in accordance with selected embodiments of the present disclosure.

### DETAILED DESCRIPTION

A phase-lock loop (PLL) circuit, design, method of operation, and architecture are described which uses a frequency detector, a solitary charge pump, a loop filter, a voltage-to-current converter featuring a dual path configuration, and a current controlled oscillator connected in feedback with a feedback divider to generate an output clock signal from the current controlled oscillator having a frequency bandwidth and peaking specifications which are controlled by generating separate proportional and integral control voltages to drive the dual path voltage-to-current converter with different path gains in accordance with selected embodiments of the present disclosure. The innovative dual path PLL architecture disclosed herein leverages a single charge pump and a low pass filter connected to a voltage-to-current converter which is uniquely structured with dedicated proportional and integral paths which enable independent control over the total proportional and integral gains of the PLL by allowing for the adjustment of the individual voltage-to-current gains associated with each path. This strategic implementation allows the disclosed PLL circuit, design, method, and architecture to realize the benefits typically associated with dual path PLL circuits while effectively avoiding the inherent design complexities often encountered in traditional dual path PLL configurations. Consequently, the disclosed single charge-pump, dual path PLL circuit offers significant advantages in terms of circuit area efficiency, power consumption, and the effort required for design and implementation when compared to conventional charge-pump PLL circuits.

In this disclosure, an improved PLL circuit, design, method, and architecture are described for addressing various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the product or test engineer's specific goals, which will vary from one implementation to another. While such a development effort might be complex and time-consuming, it would nevertheless be a routine undertaking for those of ordinary skill in the art having the benefit of this disclosure. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements.

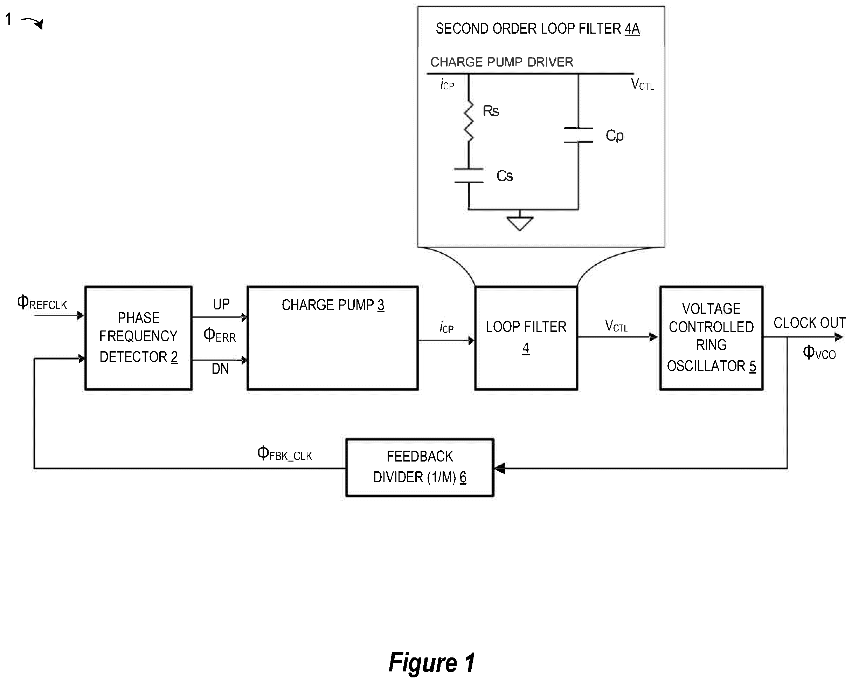

For an improved contextual understanding of the present disclosure, reference is now made to Figure 1 which illustrates a high-level block diagram of a conventional single path charge pump phase locked loop (PLL) circuit 1 which includes a phase frequency detector 2, a charge pump 3, a loop filter 4, a voltage-controlled ring oscillator 5, and a feedback divider 6 connected in feedback for input to the phase frequency detector 2. The phase frequency detector 2 receives a reference clock signal (φ_{REFCLK}) and a feedback clock signal (φ_{FBK_CLK}). The output of the phase frequency detector 2 is an error measurement value φ_{ERR} (UP, DN) that is connected to the input of the charge pump 3. The output of the charge pump 3 (*i*_{CP}) is connected to the input of the loop filter 4. Though any suitable loop filter circuit may be used, the loop filter 4 may be implemented with second order passive loop filter 4A which includes a series-connected resistor Rs and a relatively large capacitor Cs connected in parallel with a relatively small capacitor Cp to receive the charge pump output current *i*_{CP} and to generate the voltage control output signal (V_{CTL}) as shown. The voltage control output signal (V_{CTL}) of the loop filter 4 is connected to the input of the voltage-controlled ring oscillator 5. The VCO clock output signal CLOCK OUT is also provided with the output clock signal frequency φ_{VCO} to the frequency divider 6 which is connected and configured to generate a feedback signal φ_{FBK_CLK} to the phase frequency detector 2 that is a fraction (1/M) of the output clock signal frequency φ_{VCO}. In selected embodiments, the frequency divider 6 is configured to receive the output clock signal φ_{VCO}, and to generate the feedback signal φ_{FSK_CLK} based on a frequency divider control signal which may be indicative of a division factor (M) to be used for dividing the frequency of output clock signal φ_{VCO}. Frequency divider 6 may generate the feedback signal φ_{FBK_CLK} to have a frequency that is approximately equal to the quotient of the frequency of output clock signal φ_{VCO} divided by M.

In the conventional single path charge pump PLL circuit 1, the expressions for the bandwidth and damping factors (peaking spec), assuming 2^{nd} order PLL (ignoring effect of the relatively small capacitor Cp), are as follows. First, the Loop Gain may be computed as $LG \left(s\right) = \frac{{I}_{cp} {K}_{vco}}{NC} \frac{RCs + 1}{{s}^{2}}$*.* In addition, the closed loop transfer function may be computed as: $H \left(s\right) = N \frac{{I}_{cp} {K}_{vco}}{NC} \frac{RCs + 1}{{s}^{2} + \frac{{I}_{cp} {K}_{vco}}{NC} RCs + \frac{{I}_{cp} {K}_{vco}}{NC}} = N {w}_{n}^{2} \frac{\frac{2 ζ}{{w}_{n}} s + 1}{{s}^{2} + 2 {ζw}_{n} s + {w}_{n}^{2}} ,$ where the damping factor $ζ = \frac{\sqrt{\frac{{I}_{cp} {K}_{vco} C}{N}} ∗ R}{2}$, and where ${w}_{n} = \sqrt{\frac{{I}_{cp} {K}_{vco}}{NC}}$. In addition, the Closed loop bandwidth may be approximated as ${w}_{u} = \frac{R {I}_{cp} {K}_{vco}}{N}$, and the closed loop transfer function pole zero locations may be computed as: $Z 1 = \frac{{w}_{n}}{2 ζ}$ $P 1 = {ζw}_{n} - {w}_{n} \sqrt{{ζ}^{2} - 1} .$

Based on the foregoing expressions, it can be proved that P1 can never be lesser than Z1 for any positive finite ζ), and peaking for the conventional single path charge pump 1 is observed due to dominant zero Z1 placed just before the first pole P1. As damping factor ζ increases P1 moves closer to Z1 and peaking reduces. While the frequency peaking can be reduced by increasing the damping factor ζ, this will also increase the bandwidth as the same parameters are coming in both the expressions. And while same bandwidth can be maintained when reducing peaking by increasing the size of the relatively large capacitor Cs, this is not a cost-effective solution as it comes with square root factor.

As seen from the foregoing, conventional single path charge-pump PLL circuits (2^{nd} or 3^{rd} order) have bandwidth and frequency peaking performance that is dependent on same parameters and are correlated to each other. As a result, low peaking implies high bandwidth, and vice versa. In such single path charge pump PLL architectures, it is difficult to achieve both lower peaking and lower closed loop bandwidth.

To address these challenges posed by single path charge pump PLL circuits, dual path PLL architectures have been proposed to provide controlled bandwidth and low peaking with lower area. Most of the dual path PLL architectures consist of proportional and integral paths, each having a separate charge-pump to generate the proportional and integral control voltages. With separate charge-pump for each path, steady-state phase offsets can differ, and the mismatch in phase offsets can cause ripple in proportional control voltage which contributes to jitter in VCO clock. To tackle these problems, the charge pumps may require additional circuit to trim the phase offset mismatch, but this imposes additional cost and complexity in the PLL circuit design. Other solutions may require an additional DC bias voltage for biasing the proportional control voltage, but any DC bias voltage would need to be generated to approximately track PVT variations so that output frequency is maintained, and integral control voltage remains within regulated range. These solutions increase circuit complexity, design efforts and further non-idealities.

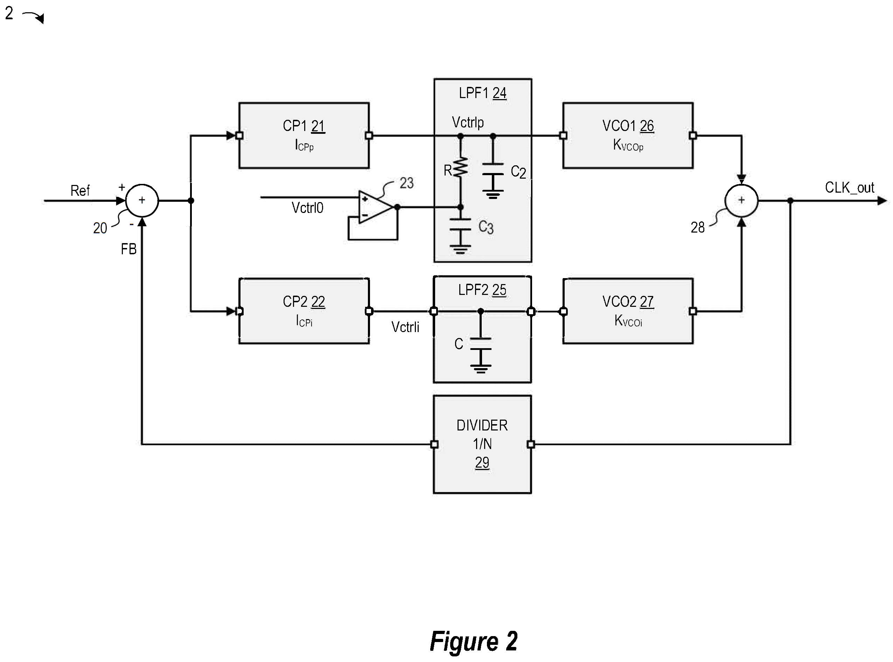

For an improved contextual understanding of the present disclosure, reference is now made to Figure 2 which illustrates a high-level block diagram of a conventional dual path charge pump PLL circuit 2 which includes a phase detector 20, a first charge pump (CP1) 21, a second charge pump (CP2) 22, an amplifier 23 connected in a feedback configuration to receive the control voltage Vctrl0, a first loop filter (LPF1) 24, a second loop filter (LPF2) 25, a first voltage controlled oscillator (VCO1) 26, a second voltage controlled oscillator (VCO2) 27, a first adder 28, and a feedback divider 29 connected in feedback for input to the phase frequency detector 20, as shown.

In operation, the phase detector 20 receives a reference signal (Ref) and a feedback signal (FB). The output of the phase detector 20 is a phase error measurement value between the reference signal (Ref) and a feedback signal (FB) that is connected to the inputs of the first charge pump 21 and the second charge pump 22. The output of the first charge pump 21 is a proportional charge pump current (I_{CPp}) that is provided to the first loop filter (LPF1) 24. Though any suitable loop filter circuit may be used, the first loop filter (LPF1) 24 may include a series-connected resistor R and a relatively large capacitor C3 connected in parallel with a relatively small capacitor C2 to generate the proportional voltage control output signal (Vctrlp) as shown. To this end, one end of the resistor R is connected to the output from the first charge pump 21, and the other end of the resistor R is connected to the output from the amplifier 23. The output of the first loop filter (LPF1) 24 is connected to the input of the first voltage controlled oscillator (VCO1) 26. Based on the foregoing, the first charge pump 21, loop filter LPF1 24, and VCO1 26 form a proportional PLL path.

In similar fashion, the error measurement value from the phase detector 20 causes the second charge pump 22 to generate the integral charge pump current (I_{CPi}) that is provided to the second loop filter (LPF2) 25 which includes a capacitor C1 connected on one end to ground to generate the integral voltage control output signal (Vctrli) as shown. The output of the second loop filter (LPF2) 25 is connected to the input of the second voltage controlled oscillator (VCO2) 27. Based on the foregoing, the second charge pump 22, loop filter LPF2 25, and VCO2 27 form an integral PLL path.

The outputs from the first and second voltage-controlled oscillators 26, 27 are summed at the first adder 28 which generates the output clock signal CLK_out. The output clock signal CLK_out from the first adder 28 is connected over the feedback divider 29 that is configured to generate a feedback signal FB to the phase frequency detector 20 that is a fraction (1/N) of the output clock signal CLK_out. Frequency divider 29 may generate the feedback signal FB to have a frequency that is approximately equal to the quotient of the frequency of output clock signal CLK_out divided by N.

In the conventional dual path charge pump PLL circuit 2, the expressions for the bandwidth and damping factors (peaking spec), assuming 2^{nd} order PLL (ignoring effect of the relatively small capacitor C2), are as follows. First, the Loop Gain may be computed as $LG \left(s\right) = \frac{{I}_{cpi} {K}_{vcoi}}{NC} \frac{\frac{{RI}_{cpp} {K}_{vcop}}{{I}_{cpi} {K}_{vcoi}} Cs + 1}{{s}^{2}}$*.* In addition, the closed loop transfer function may be computed as: $H \left(s\right) = N \frac{{I}_{cpi} {K}_{vcoi}}{NC} \frac{\frac{{RI}_{cpp} {K}_{vcop}}{{I}_{cpi} {K}_{vcoi}} Cs + 1}{{s}^{2} + \frac{{RI}_{cpp} {K}_{vcop}}{N} s + \frac{{I}_{cpi} {K}_{vcoi}}{NC}} = N {w}_{n}^{2} \frac{\frac{2 ζ}{{w}_{n}} s + 1}{{s}^{2} + 2 {ζw}_{n} s + {w}_{n}^{2}}$, where the damping factor $ζ = \frac{R {I}_{cpp} {K}_{vcop}}{2} \sqrt{\frac{C}{N {I}_{cpi} {K}_{vcoi}}}$, and where ${w}_{n} = \sqrt{\frac{{I}_{cpi} {K}_{vcoi}}{NC}}$. In addition, the Closed loop bandwidth may be approximated as ${w}_{u} = \frac{R {I}_{cpp} {K}_{vcop}}{N}$, and the closed loop transfer function pole zero locations may be computed as: $Z 1 = \frac{{w}_{n}}{2 ζ}$ $P 1 = {ζw}_{n} - {w}_{n} \sqrt{{ζ}^{2} - 1} .$

Based on the foregoing expressions, it can be seen that the bandwidth is purely dependent on proportional path gain and can be set as desired. Once bandwidth is set, peak specification can be achieved by increasing the damping factor (and hence peaking is reduced) by reducing integral path gain (which comes in the denominator of ζ expression), thereby maintaining the same gain of the proportional path. In this way, both the bandwidth and peaking specifications can be achieved with a dual path PLL by controlling the gains of the proportional and integral paths.

As will be appreciated by those skilled in the art, conventional dual path PLL circuits, such as the one depicted in Figure 2, face several design challenges. One significant limitation is that the PLL output clock can include deterministic jitter due to charge-pump offsets mismatch. Charge pumps, in general, exhibit non-zero phase offsets resulting from current mismatch and/or charge injection effects. In dual-path PLLs, a mismatch exists between the phase offsets of the two charge pumps 21, 22 across various statistical corners. The integral path, by its nature, integrates the error over time, effectively providing infinite gain. Consequently, in steady state operation, the phase offset of the negative feedback loop becomes the same as that of the integral path, due primarily to the charge pump 22 within the integral path. Because the phase offset of the proportional path can differ from that of the integral path, the proportional path experiences a non-zero phase error in each cycle during steady state operation. This discrepancy leads to slight charging/discharging of the proportional control voltage node (Vctrlp). For proper biasing of the proportional control voltage (Vctrlp), the bias voltage (Vctrl0) drives the DC level of the Vctrlp node through the buffer amplifier 23. Therefore, after the slight charging/discharging in each cycle, the proportional control voltage (Vctrlp) gradually settles back to Vctrl0 with an approximate time constant of RC2. This behavior repeats in each cycle during steady state, causing ripple in the proportional control voltage (Vctrlp) due to the offset mismatch, which, in turn, causes jitter in the VCO output clock.

Another design challenge involves biasing the proportional control voltage to limit the integral control voltage (Vctrli) within the allowable range. The proportional control voltage (Vctrlp), when biased to the reference voltage (Vctrl0) through the buffer amplifier 23, settles to Vctrl0 in steady state, where Vctrl0 is an externally generated voltage bias. Because the Kvcoi of the second VCO2 27 is comparatively less, across PVT, the integral control voltage Vctrli must vary significantly to compensate for the frequency change and maintain the output frequency in the negative feedback loop. To keep the integral control voltage Vctrli variation within the allowable range, Vctrl0 should track the variation needed across PVT to maintain an almost constant output frequency.

A further design challenge is the slow settling of control voltages during transients, which increases lock time. Even though the output clock frequency settles according to the closed-loop bandwidth during transients, to achieve lesser peaking, the integral path gain is kept comparatively very low. Consequently, it takes a considerable amount of time for the integral control voltage Vctrli to charge to the expected level, even with finite phase error. During this time, ripple in Vctrlp, and hence deterministic jitter in the output frequency, is observed due to the phase error. The total locked state is assumed only when Vctrli reaches the expected value and the jitter due to Vctrlp ripple dies out, which increases the time needed to lock.

As seen from the foregoing, the dual path PLL circuit architectures address some of the limitations of the single path charge pump PLL circuit, but there are challenges that remain caused by offset mismatch between the two charge pumps and providing proper DC bias for the proportional control voltage. And while solutions have been proposed to address these challenges of the dual path PLL circuits, implementing those solutions is a challenging task and needs a lot more design efforts. To address these deficiencies with conventional PLL circuits and others known to those skilled in the art, the present disclosure proposed to combine the best features of both the single and dual path architectures by using single charge-pump to eliminate the design challenges from dual path PLL circuits, while also separating out the integral and proportional paths at control voltage stage. Generally speaking, the disclosed single charge pump, dual path PLL circuit uniquely provides a dual path PLL having single charge-pump and low pass filter in similar manner as single path charge-pump PLL. The proportional and integral paths are separated out at a later stage (in the voltage-to-current converter) so that the total proportional and integral gains can be controlled independently by controlling individual VCO gains. With single charge-pump dual path architecture, advantages of dual path PLL are achieved without facing any design challenges that are observed in dual path PLL. Also, the circuit is efficient in terms of area, power and design efforts as compared to conventional dual path charge-pump PLL

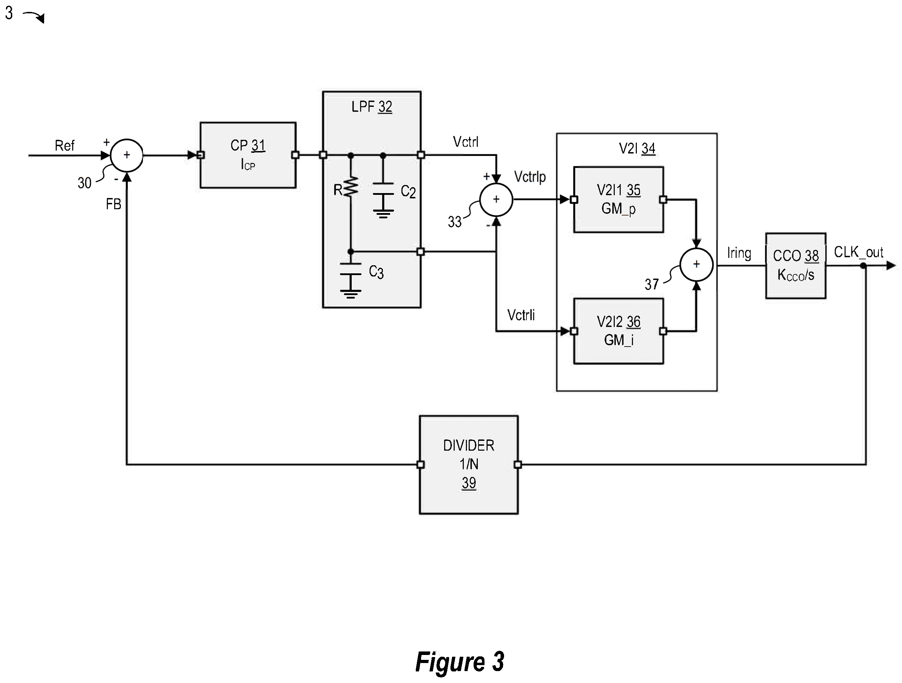

For an improved understanding of selected embodiments of the present disclosure, reference is now made to Figure 3 which illustrates a high-level block diagram of a single charge pump, dual path PLL circuit 3 which includes a phase detector 30, a single charge pump (CP1) 31, a loop filter (LPF) 32, a voltage subtractor circuit 33, a voltage to current converter (V2I) 34 (which includes a first voltage to current converter (V2I1) 35, a second voltage to current converter (V2I2) 36, and a current adder circuit 37), a current controlled oscillator (CCO) 38, and a feedback divider 39 connected in feedback for input to the phase frequency detector 30, as shown. The phase detector 30 receives a reference signal (Ref) and a feedback signal (FB). The output of the phase detector 30 is connected to the input of the first charge pump 31. The output of the first charge pump 31 provides a charge pump current (Icp) to the input of the loop filter 32. The loop filter 32 includes a series-connected resistor R and capacitor C3 connected in parallel with a capacitor C2 to generate the control voltage Vctrl as shown. To this end, one end of the resistor R is connected to a first voltage control output Vctrl from the loop filter 32, and the other end of the resistor R is connected to a second integral voltage control output Vctrli from the output from the loop filter 32. The first voltage control output Vctrl of the loop filter 32 (Vctrl) is connected to a first positive input of the voltage subtractor circuit 33, and the second integral voltage control output Vctrli of the loop filter 32 (Vctrli) is connected to a second negative input of the voltage subtractor circuit 33. At the voltage-to-current (V2I) converter 34, the output of the voltage subtractor circuit 33 is connected to the first voltage to current converter (V2I1) 35, and the second integral voltage control output Vctrli is connected to the voltage to current converter (V2I2) 36. In addition, the current output from the first voltage to current converter (V2I1) 35 is connected to a first input of the current adder circuit 37, and the current output from the second voltage to current converter (V2I2) 36 is connected to a second input of the current adder circuit 37. The output of the current adder circuit 37 is the ring current Iring which is provided to the current controlled oscillator (CCO) 38 which generates the output clock signal CLK_out. The output clock signal CLK_out from the CCO 38 is connected over the feedback divider 39 that is configured to generate a feedback signal FB to the phase frequency detector 30 that is a fraction (1/N) of the output clock signal CLK_out. Frequency divider 39 may generate the feedback signal FB to have a frequency that is approximately equal to the quotient of the frequency of output clock signal CLK_out divided by N.

As depicted, the single charge pump, dual path PLL circuit 3 employs a single charge pump 31 and a low pass filter (LPF) 32 to generate the control voltage Vctrl in the same way as a single path charge pump PLL. Based on the understanding that the control voltage Vctrl inherently includes two components -- a first voltage drop across C3 representing the integral component, and a voltage drop across R representing the proportional component - the *proposed PLL circuit 3* separates these two components and uses them to independently drive the VCO block with different gains. This approach allows for the separate adjustment of path gains corresponding to the integral and proportional paths, analogous to dual path PLLs, by altering the Kvcoi to Kvcop ratio, despite employing a single charge pump current Icp. Insofar as the control voltage is equal to the sum of the proportional and integral control voltages, the proportional control voltage Vctrlp may be derived as the difference between the control voltage Vctrl and the integral control voltage Vctrli. To this end, the voltage subtractor circuit 33 is used to realize the voltage-to-current conversion corresponding to the proportional control voltage Vctrlp by applying a subtraction operation at the voltage subtractor circuit 33 within the voltage-to-current converter block 34. However, it will be appreciated that other methods for performing the subtraction operation are can be used.

A primary advantage of single charge pump, dual path PLL design is that the proportional control voltage does not require a separately generated DC bias voltage. Additionally, the use of a solitary, shared charge pump in both paths is advantageous because, even if the charge pump has a non-zero offset, the offset mismatch between the two paths is always zero. This eliminates any jitter originating from offset mismatch, a common issue in conventional dual path PLL architectures. Another advantage of the single charge pump, dual path PLL design is that a smaller device area is required since there is only a single charge pump component. In addition, further reductions in charge-pump device sizes are possible since there is no need to optimize random offset, a requirement in conventional dual path designs to reduce offset mismatch.

In the disclosed single charge pump, dual path charge pump PLL circuit 3, the expressions for the loop gain, closed loo transfer function, damping factor, and bandwidth are the same as the conventional dual path PLL, assuming 2^{nd} order PLL (ignoring effect of the relatively small capacitor C2), where *I*_{CPp} = *I*_{CPi} = *I*_{CP}. First, the Loop Gain may be computed as $LG \left(s\right) = \frac{{I}_{cp} {K}_{vcoi}}{NC} \frac{\frac{{RK}_{vcop}}{{K}_{vcoi}} Cs + 1}{{s}^{2}}$*.* In addition, the closed loop transfer function may be computed as: $H \left(s\right) = N \frac{{I}_{cp} {K}_{vcoi}}{NC} \frac{\frac{{RK}_{vcop}}{{K}_{vcoi}} Cs + 1}{{s}^{2} + \frac{{RI}_{cp} {K}_{vcop}}{N} s + \frac{{I}_{cp} {K}_{vcoi}}{NC}} = N {w}_{n}^{2} \frac{\frac{2 ζ}{{w}_{n}} s + 1}{{s}^{2} + 2 ζ {w}_{n} s + {w}_{n}^{2}}$, where the damping factor $ζ = \frac{R {K}_{vcop}}{2} \sqrt{\frac{{I}_{cp} C}{N {K}_{vcoi}}}$, and where ${w}_{n} = \sqrt{\frac{{I}_{cp} {K}_{vcoi}}{NC}}$. In addition, the Closed loop bandwidth may be approximated as ${w}_{u} = \frac{R {I}_{cp} {K}_{vcop}}{N}$, and the closed loop transfer function pole zero locations may be computed as: $Z 1 = \frac{{w}_{n}}{2 ζ}$ $P 1 = {ζw}_{n} - {w}_{n} \sqrt{{ζ}^{2} - 1} .$

Based on the foregoing expressions, it can be seen that the bandwidth specification is met by fixing the proportional path gain. In addition, the peaking specification is met by realizing large damping factor by large ratio of Kvcop:Kvcoi and adjusting Icp current accordingly.

In an example embodiment, the following loop parameters may be used with the single charge pump, dual path charge pump PLL circuit 3 to achieve a bandwidth *wᵤ <* 500kH and a peaking spec **P1** < 150 mdB:

| | | | |
|---|---|---|---|
| Icp = 5uA | Bandwidth (Hz) | Peaking (dB) | Phase Margin |
| Kvcop = 12GHz/V, Kvcoi = 1GHz/V | | | |
| | 475.8k | 103.3m | 84.37 |
| C = 200pF, R = 10kΩ, C2 = 3pF | | | |
| N = 220 (F_Ref=25M & Fout = 5.5GHz) | | | |

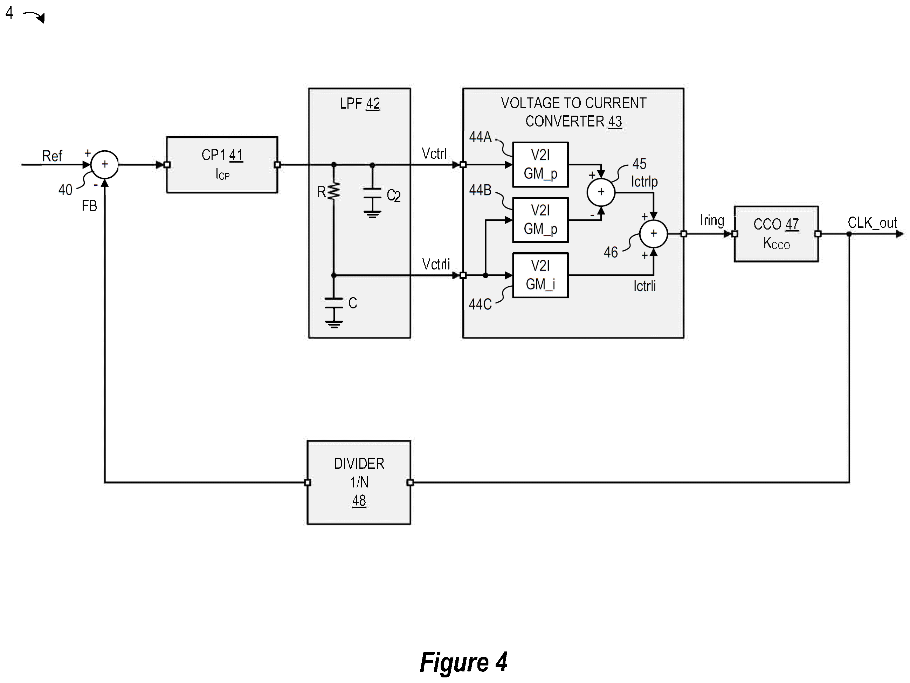

For an improved understanding of selected embodiments of the present disclosure, reference is now made to Figure 4 which illustrates a high-level block diagram of a single charge pump, dual path PLL circuit 4 which includes a phase detector 40, a single charge pump (CP1) 41, a loop filter (LPF) 42, a voltage to current converter 43, a shared current controlled oscillator (CCO) 47, and a feedback divider 48 connected in feedback for input to the phase frequency detector 40, as shown. As disclosed, the voltage to current converter 43 includes a first voltage to current converter V2I 44A having a configurable transconductance gain GM_p that is connected to receive the control voltage Vctrl and to generate a first output current which corresponds to Ictrli + Ictrlp. The disclosed voltage to current converter 43 also includes a second voltage to current converter V2I 44B having a configurable transconductance gain GM_p that is connected to receive the integral control voltage Vctrli and to generate a second output current which corresponds to Ictrli. In addition, the disclosed voltage to current converter 43 includes a third voltage to current converter V2I 44C having a configurable transconductance gain GM_i that is connected to receive the integral control voltage Vctrli and to generate a third output current which correspond to the integral control current Ictrli. The voltage to current converter 43 also includes a first (current) subtractor circuit 45 connected to the output currents from the first and second voltage to current converters 44A, 44B to generate the proportional control current Ictrlp. In addition, the voltage to current converter 43 includes a second (current) adder circuit 46 connected to receive the proportional control current Ictrlp from the first (current) subtractor circuit 45 and connected to receive the integral control current ring current Ictrli from the third voltage to current converter 44C to generate the control current ring current Iring.

In operation, the phase detector 40 receives a reference signal (Ref) and a feedback signal (FB). The output of the phase detector 40 is connected to the input of the single charge pump 41. The output of the single charge pump 41 (Icp) is connected to the input of the loop filter 42. The loop filter 42 includes a series-connected resistor R and capacitor C connected in parallel with a capacitor C2 to generate the control voltage Vctrl and the integral control voltage Vctrli, as shown. To this end, one end of the resistor R is connected to a first voltage control output Vctrl from the loop filter 42, and the other end of the resistor R is connected to an integral voltage control output Vctrli from the loop filter 42. The first voltage control output Vctrl of the loop filter 42 is connected to the first voltage to current converter V2I 44A, and the integral voltage control output Vctrli of the loop filter 42 is connected to the second and third voltage to current converters 44B, 44C. In response to the control voltage Vctrl, the first voltage to current converter V2I 44A generates the first output current that is provided to the first (current) subtractor circuit 45. In response to the integral control voltage Vctrli, the second voltage to current converter V2I 44B generates the second output current that is provided to the first (current) subtractor circuit 45. In response to the first and second output currents, the first (current) subtractor circuit 45 generates the proportional control current Ictrlp which is provided to the second (current) adder circuit 46. In response to the integral control voltage Vctrli, the third voltage to current converter V2I 44C generates the integral control current Ictrli that is provided to the second (current) adder circuit 46. In response to the proportional and integral control currents, the second (current) adder circuit 46 generates the oscillator ring current Iring. The output of the second adder is labeled Iring. The output of the second (current) adder circuit 46 (Iring) is provided to the current controlled oscillator (CCO) 47 to generate the output clock signal CLK_out which is connected over the feedback divider 48 to the phase detector 40.

In function and effect, the first and second voltage to current converters 44A, 44B and first (current) subtractor circuit 45 are connected in a first path to generate the proportional control current Ictrlp as a function of a first configurable transconductance gain value GM_p. In addition, the third voltage to current converter 44C is connected in a second path to generate the integral control current Ictrli as a function of a second configurable transconductance gain value GM_i. In comparison to the voltage to current converter (V2I) 34 depicted in Figure 3 wherein the voltage to current converters 35, 36 are characterized by the VCO gain values (GM_p, GM_i), the voltage to current converters 44A/B, 42C are characterized by the corresponding transconductance gain values GM_p, GM_i) with the equations K_{VCOp} = GM_p * K_{CCO} and K_{VCOi} = GM_i * K_{CCO}. Thus, the configurable transconductance gain values GM_p, GM_i) enable control of the bifurcation of proportional and integral control paths by controlling the sizing the proportional control path FET devices and integral control path FET devices. And by forming the proportional and integral control paths with the voltage to current converters 44A-C, the bifurcation of proportional and integral controls can be readily implemented in terms of currents with the first (current) subtractor circuit 45 and second (current) adder circuit 46 in the voltage to current converter 43. Since voltage to current converter circuits are generally included in the VCO block in almost every PLL application, implementation of this technique is relatively straightforward.

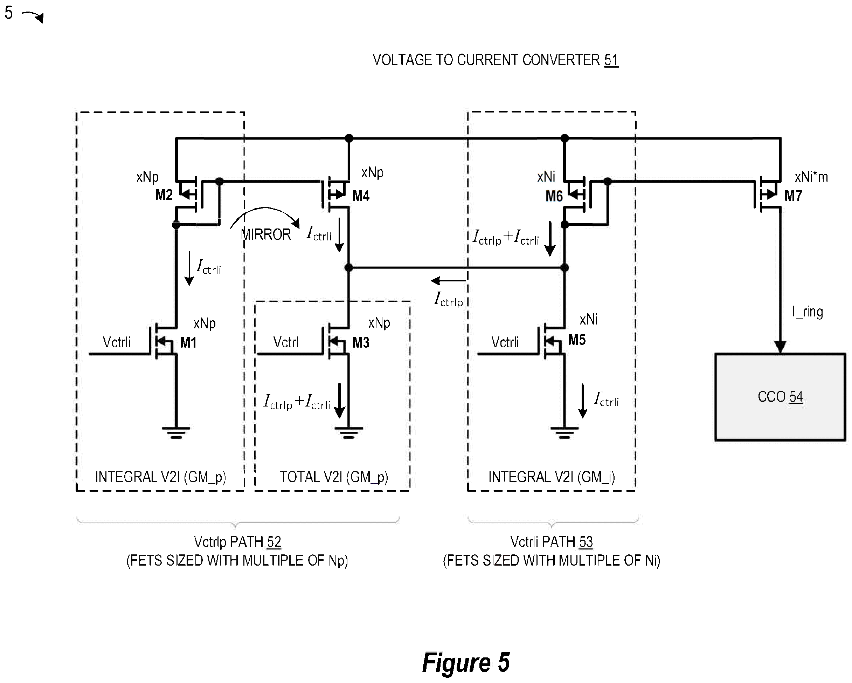

For an improved understanding of selected embodiments of the present disclosure, reference is now made to Figure 5 which depicts a circuit schematic diagram 5 of a voltage-to-current converter 51 and shared charge control oscillator 55. As disclosed, the voltage-to-current converter 51 includes a first current mirror path 52 connected with a second current mirror path 53 to generate the ring oscillator current Iring that is provided to the shared CCO 55. The first current mirror path 52 includes a first current branch (formed with series-connected NFET transistor M1 and PFET transistor M2) and a second current branch (formed with series-connected NFET transistor M3 and PFET transistor M4). The second current mirror path 53 includes a third current branch (formed with series-connected NFET transistor M5 and PFET transistor M6), and a fourth current branch (formed with PFET transistor M7). In the first current mirror path 52, each of the transistors M1-M4 is sized as a multiple of Np. And in the second current mirror path 53, each of the transistors M6-M7 is sized as a multiple of Ni, and the transistor M7 is sized as a multiple of Ni*m.

With the integral control voltage Vctrli corresponding to the voltage drop across the loop filter capacitor C being connected to gate the NFET transistor M5, the third current branch M5/M6 generates an integral control current Ictrli corresponding to the integral control voltage Vctrli, thereby functioning as the third V2I converter 44C in Figure 4 having a transconductance gain GM_i. To separately generate the proportional control current Ictrlp, the first and second current branches are connected to effectively perform a current subtraction operation by subtracting the integral control current (Ictrli) from the total control current (Ictrli + Ictrlp). To this end, the first current branch M1/M2 generates an integral control current Ictrli corresponding to the integral control voltage Vctrli, thereby functioning as the second V2I converter 44B in Figure 4 having a transconductance gain GM_p. In particular, the integral control voltage Vctrli is connected to gate the NFET transistor M1 so that the first current branch M1/M2 generates an integral control current Ictrli. When the integral control current is mirrored to the second current branch M3/M4, the second current branch M3/M4 generates a total control current (Ictrli + Ictrlp) corresponding to the control voltage Vctrl, thereby functioning as the first V2I converter 44A in Figure 4 having a transconductance gain GM_p. In particular, the control voltage Vctrl is connected to gate the NFET transistor M3 so that the second branch M3/M4 generates a current corresponding to the total current (Ictrl = Ictrli + Ictrlp) across the NFET transistor M3. By connecting the first and second current branches in the first current mirror path 52 to the second current mirror path 53 as shown, the first two branches M1/M2, M3/M4 effectively subtract the integral control current from the total control current to generate the proportional control current, as shown. By mirroring the first branch current in the second branch, the current corresponding to Vctrli is negated or subtracted from the current corresponding to Vctrl, effectively causing the NFET transistor M3 to sink additional current corresponding to Vctrlp. In the third current branch M5/M6, the NFET transistor M5 sinks current corresponding to integral control voltage Vctrli. In addition, the proportional and integral currents sunk by the NFET transistors M3, M5 are mirrored by the PFET transistors M6, M7 with a multiplier m. In this way, the proportional and integral gains can be set independently with multipliers Np and Ni, respectively.

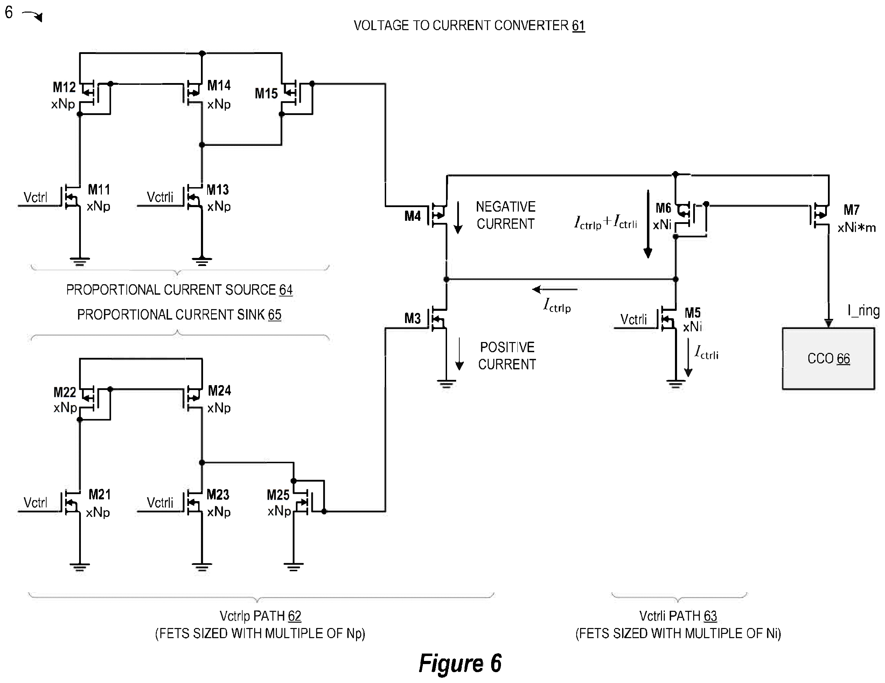

As will be appreciated by persons skilled in the art, the use of dual PLL paths to bifurcate the integral and proportional gain factors can be implemented in a variety of different ways. For example, reference is now made to Figure 6 which depicts a circuit schematic diagram 6 of a voltage-to-current converter 61 and shared current controlled oscillator 66 which are connected and configured to implement a gain bifurcation for the single charge pump, dual path PLL circuit in accordance with selected embodiments of the present disclosure. As disclosed, the voltage-to-current converter 61 includes a first current mirror path 62 connected with a second current mirror path 63 to generate the ring oscillator current Iring that is provided to the shared CCO 66. The first current mirror path 62 includes a proportional current source circuit 64 having a first current source branch (formed with transistors M11-M14 connected as a current mirror to a diode-connected PFET transistor M15), and also includes a proportional current sink circuit 65 having a first current sink branch (formed with transistors M21-M24 connected as a current mirror to a diode-connected NFET transistor M25), as shown. In addition, the first current mirror path 62 includes a second current branch (formed with series-connected NFET transistor M3 and PFET transistor M4), as shown. The second current mirror path 63 includes a third current branch (formed with series-connected NFET transistor M5 and PFET transistor M6), and a fourth current branch (formed with PFET transistor M7). In the first current mirror path 62, each of the transistors M11-M14, M21-M24 is sized as a multiple of Np. And in the second current mirror path 63, each of the transistors M6-M7 is sized as a multiple of Ni, and the transistor M7 is sized as a multiple of Ni*m.

As disclosed, the proportional current source circuit 64 and the proportional current sink circuit 65 are connected and configured to handle proportional current flow in different directions, which is important because the charge-pump current can sometimes be negative, resulting in the integral control voltage Vctrli being at a higher potential than the control voltage Vctrl. In particular, the proportional current source circuit 64 may include a cascaded PFET current mirror circuit M11-M14 that is formed with first series-connected NFET transistor M11 and PFET transistor M12, a second series-connected NFET transistor M13 and PFET transistor M14, and a diode-connected output PFET transistor M15. When the charge pump current is negative, the proportional current source circuit 64 mirrors and sources the proportional current through the diode-connected output PFET transistor M15. When the proportional current source circuit 64 is connected over the diode-connected output PFET transistor M15 to the second current branch M3/M4, the mirrored proportional current is subtracted from the integral current.

And to handle cases when the charge pump current is positive, the proportional current sink circuit 65 may include a cascaded PFET current mirror circuit M21-M24 that is formed with third series-connected NFET transistor M21 and PFET transistor M22, a fourth series-connected NFET transistor M23 and PFET transistor M24, and a diode-connected output NFET transistor M25. When the charge pump current is positive, the proportional current sink circuit 65 mirrors and sinks the proportional current through the diode-connected output NFET transistor M25. When the proportional current sink circuit 65 is connected over the diode-connected output NFET transistor M25 to the second current branch M3/M4, the mirrored proportional current is added to the total sink current which is drawn from diode-connected NFET transistor 25 and hence gets mirrored to the CCO ring current by the third and fourth current branches connected to form a current mirror for the CCO 66.

In operation, the proportional current source circuit 64 mirrors and sources the proportional current through the diode-connected output PFET transistor M15 when the proportional current is negative. This current is then subtracted from the integral current. However, when the proportional current is positive, the proportional current sink circuit 65 mirrors and sinks the proportional current. As a result, this current is added to the total sink current which is drawn from the diode-connected PFET transistor M6. The current drawn from M6 is then mirrored to the CCO ring current via PFET transistor M7. As a result, the proportional current, whether positive or negative, is added to or subtracted from the integral current to generate a total CCO ring current, and the integral current is always positive. And in a steady-state locked condition, the ring current is primarily driven by the integral current, and the contribution of the proportional path becomes negligible as Vctrlp tends to zero.

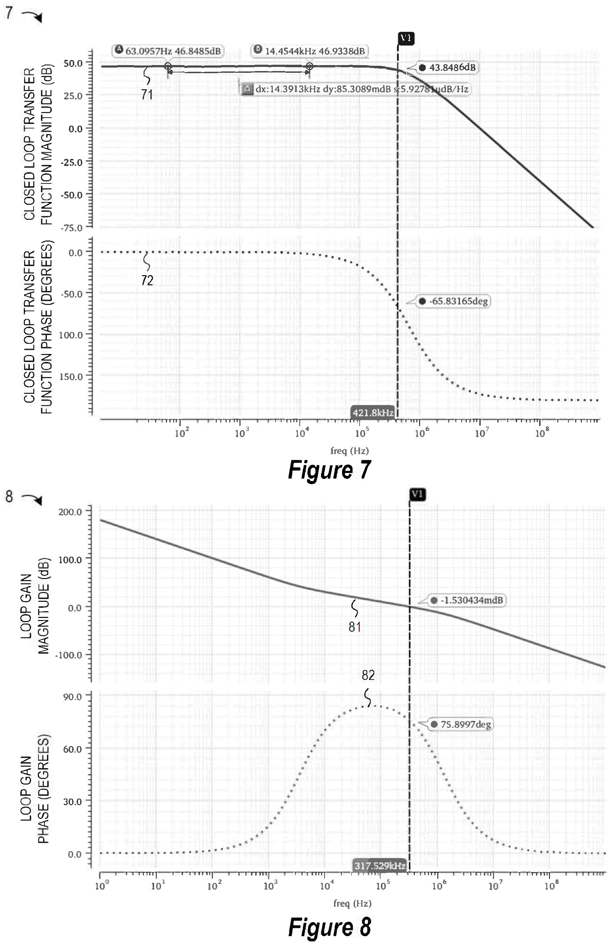

For an improved understanding of selected embodiments of the present disclosure, reference is now made to Figure 7 which depicts a simulated plot 7 of the closed-loop transfer function magnitude 71 and phase 72 for an example single charge pump dual path PLL circuit. In addition, reference is made to Figure 8 which depicts a simulated plot 8 of the loop gain magnitude 81 and phase 82 for an example single charge pump dual path PLL circuit. In the example simulation plots, the single charge pump, dual path PLL circuit 3 shown in Figure 3 was configured with the following parameter values:

| **Parameter** | **Value** |
|---|---|
| I_cp | 2uA |
| Kvcop | 15GHz/V |
| Kvcoi | 1GHz/V |
| N | 220 |
| C3 | 200pF |
| R | 15kΩ |
| C2 | 8pF |

Based on the plot 7 of the closed loop transfer function magnitude 71 and phase 72, it can be seen that the bandwidth (421.8 kHz) is below 500 kHz. Also, it can be seen that the low peaking spec (85.3 mdB) is achieved. Set forth in the table below is the measured values for the damping factor ζ, bandwidth, peaking values, phase margin, and pole zero locations:

| ζ | Bandwidth (Hz) | Peaking (dB) | Phase Margin | z1 | p1 | p2 |
|---|---|---|---|---|---|---|
| 4.8 | 421.8k | **85.3m** | 75.9 | -3.54k | -3.57k | -321.9k |

As seen from the foregoing, the bifurcation of only Kvco in two paths is enough to simultaneously achieve both peaking and bandwidth specs. In steady state operation of the single charge pump, dual path PLL circuit, the control voltage Vctrl and integral control voltage Vctrli settle to same DC level, indicating there is zero phase error. In addition, there is no ripple observed in the proportional control voltage Vctrlp since there is no phase offset mismatch from different charge pumps. In addition, there is minimal jitter during steady state which is similar to a conventional single path PLL circuit. Another benefit of the disclosed single charge pump, dual path PLL circuit is that there is no requirement to provide any DC bias in the loop filter for the proportional control voltage. This also eliminates the problem with slow settling from conventional PLL circuits since the single, solitary charge-pump means that the integral capacitor in the loop filter is getting charged with the same charge-pump current, and not with reduced current as that of conventional dual path architecture.

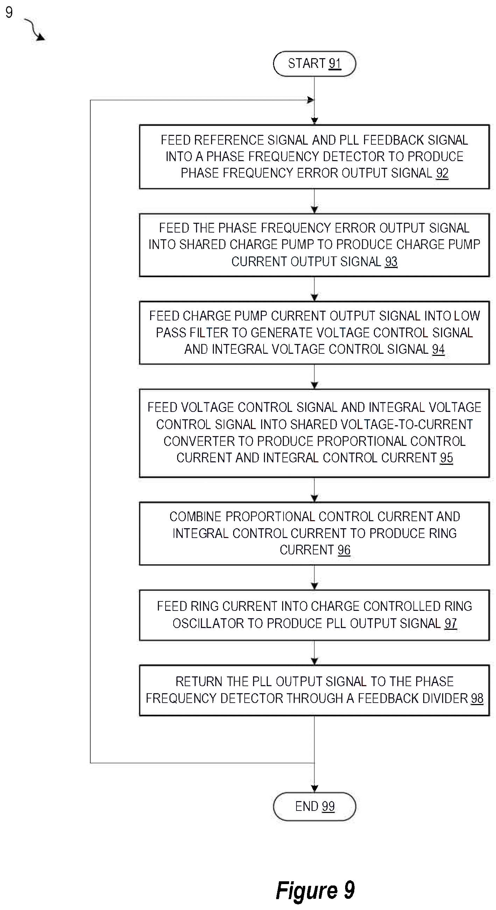

Turning now to Figure 9, there is shown a simplified flowchart diagram 9 showing the logic for controlling the operation of a single charge pump dual path PLL circuit in accordance with selected embodiments of the present disclosure. When the operation of the PLL starts (91), the PLL circuit feeds a reference signal and a PLL feedback signal into the phase frequency detector to produce a phase frequency error output signal (step 92). Next, the PLL circuitry feeds the phase frequency error output signal into a single, solitary shared charge pump to produce a charge pump current output signal (step 93). Next (step 94), the charge pump current output signal is fed into a low pass filter, such as second order loop filter, to generate a voltage control signal Vctrl and an integral voltage control signal Vctrli. At step 95, the voltage control signal and integral voltage control signal are fed into a shared voltage-to-current converter to produce a proportional control current Ictrlp and an integral control current Ictrli. At step 96, the proportional control current Ictrlp and integral control current Ictrli are combined to produce the ring current Iring. At step 97, the ring current Iring is fed into a charge controlled oscillator (CCO) to produce a PLL output clock signal. At step 98, the PLL output clock signal is returned to the phase frequency detector through a feedback divider, and the steps 92-98 are repeated until the method ends (step 99).

By now, it should be appreciated that there has been provided a phase-locked loop (PLL) circuit, method of operation, system, and apparatus for generating a PLL clock output signal. In the disclosed methodology and apparatus, the PLL includes a phase-frequency detector (PFD) connected to receive an input reference signal and a feedback clock signal as inputs and configured to produce a PFD error output signal. In addition, the PLL includes a single charge pump connected to receive the PFD error output signal as an input and configured to produce a charge pump control current. The PLL also includes a loop filter connected to receive the charge pump control current and configured to generate a voltage control signal (V_{CTL}) and an integral voltage control signal (V_{CTLi}). In selected embodiments, the loop filter includes a series-connected resistor Rs and capacitor Cs, where the loop filter is connected and configured to generate the voltage control signal (V_{CTL}) from one end of the resistor Rs and to generate the integral voltage control signal (V_{CTLi}) from another end of the resistor Rs. In addition, the PLL includes a dual path voltage-to-current converter circuit that is connected to receive the voltage control signal (V_{CTL}) and the integral voltage control signal (V_{CTLi}), and that is configured with two separate paths having separate gains to generate a proportional control current and an integral control current that are combined to generate a ring oscillator control signal. In selected embodiments, the dual path voltage-to-current converter circuit includes a proportional current path having a first gain value for generating a proportional control current, an integral current path having a second, different gain value for generating an integral control current, and an addition circuit for summing the proportional control current and integral control current to generate the ring oscillator control signal. In such embodiments, the proportional current path may include a first voltage-to-current converter having a proportional transconductance gain value connected to convert the voltage control signal (V_{CTL}) to a first current control signal (I_{CTL}); a second voltage-to-current converter having the proportional transconductance gain value connected to convert the integral voltage control signal (V_{CTLi}) to a first integral current control signal (I_{CTLi}); and a subtraction circuit connected to generate the proportional control current by subtracting the first integral current control signal (I_{CTLi}) from the current control signal (I_{CTL}). In selected embodiments, the first and second voltage-to-current converters may be formed with FET devices having a first multiple Np of a unit size. In selected embodiments, the integral current path may include a third voltage-to-current converter having an integral transconductance gain value connected to convert the integral voltage control signal (V_{CTLi}) to the integral current control current. In such embodiments, the third voltage-to-current converter is formed with FET devices having a second multiple Ni of a unit size, where Ni ≠ Np. The PLL also includes a current controlled oscillator which is connected to receive the ring oscillator control signal and configured to produce a PLL clock output signal. In addition, the PLL includes a feedback clock divider connected to receive the PLL clock output signal as an input and configured to produce the feedback clock signal for return to the phase-frequency detector. In selected embodiments, the dual path voltage-to-current converter circuit may include a first current branch connected to receive the integral voltage control signal (V_{CTLi}) and configured with a first integral gain value to generate a first integral current control signal; a second current branch connected to receive the integral voltage control signal (V_{CTLi}) and configured with a second proportional gain value to generate a integral current control signal; and a third current branch connected to receive the voltage control signal (V_{CTL}) and configured with the second proportional gain value to generate a first current control signal; where the second current branch is connected to be mirrored in the third current branch to subtract the integral current control signal from the first current control signal, thereby generating a first proportional control signal that is combined with the first integral current control signal to generate the ring oscillator control signal.

In another form, there is provided a single charge-pump dual path phase locked loop (PLL) circuit and associated method of operation. In the disclosed method, a phase-frequency detector generates a phase-frequency error measure by detecting a phase difference between an input reference signal and a feedback clock signal. The disclosed method also generates a charge pump control current at a single charge-pump in response to the phase-frequency error measure. In addition, the disclosed method filters the charge pump control current with a loop filter to produce a voltage control signal (V_{CTL}) and an integral voltage control signal (V_{CTLi}). In selected embodiments, the charge pump control current is filtered by supplying the phase-frequency error measure to a first end of a series-connected resistor Rs and capacitor Cs which has a second end connected to ground, where the loop filter is connected and configured to generate the voltage control signal (V_{CTL}) from one end of the resistor Rs and to generate the integral voltage control signal (V_{CTLi}) from another end of the resistor Rs. The disclosed method also generates a proportional control current and an integral control current at a dual path voltage-to-current converter circuit in response to the voltage control signal (V_{CTL}) and the integral voltage control signal (V_{CTLi}), where the dual path voltage-to-current converter circuit is configured with two separate paths having separate gains to generate the proportional control current and the integral control current. In addition, the disclosed method combines the proportional control current and the integral control current to generate a ring oscillator control signal. In selected embodiments, the proportional control current is generated by supplying the voltage control signal (V_{CTL}) and the integral voltage control signal (V_{CTLi}) to a proportional current path in the dual path voltage-to-current converter circuit having a first gain value for generating the proportional control current. In such embodiments, the integral control current may be generated by supplying the integral voltage control signal (V_{CTLi}) to an integral current path in the dual path voltage-to-current converter circuit having a second, different gain value for generating the integral control current. In such embodiments, the proportional control current and the integral control current may be combined by supplying the proportional control current and the integral control current to an addition circuit which is configured and connected to generate the ring oscillator control signal. In selected embodiments, the proportional current path may include a first voltage-to-current converter having a proportional transconductance gain value connected to convert the voltage control signal (V_{CTL}) to a first current control signal (I_{CTL}); a second voltage-to-current converter having the proportional transconductance gain value connected to convert the integral voltage control signal (V_{CTLi}) to a first integral current control signal (I_{CTLi}); and a subtraction circuit connected to generate the proportional control current by subtracting the first integral current control signal (I_{CTLi}) from the current control signal (I_{CTL}). In such embodiments, the first and second voltage-to-current converters are formed with FET devices having a first multiple Np of a unit size. In other selected embodiments, the integral current path may include a third voltage-to-current converter having an integral transconductance gain value connected to convert the integral voltage control signal (V_{CTLi}) to the integral current control current. In such embodiments, the third voltage-to-current converter is formed with FET devices having a multiple Ni of a unit size that is different from a multiple Np of the unit size used with FET devices forming the proportional current path. In other selected embodiments, the dual path voltage-to-current converter circuit may include a first current branch connected to receive the integral voltage control signal (V_{CTLi}) and configured with a first integral gain value to generate a first integral current control signal; a second current branch connected to receive the integral voltage control signal (V_{CTLi}) and configured with a second proportional gain value to generate a integral current control signal; and a third current branch connected to receive the voltage control signal (V_{CTL}) and configured with the second proportional gain value to generate a first current control signal; where the second current branch is connected to be mirrored in the third current branch to subtract the integral current control signal from the first current control signal, thereby generating a first proportional control signal that is combined with the first integral current control signal to generate the ring oscillator control signal. The disclosed method also generates a PLL clock output signal with a current controlled oscillator in response to the ring oscillator control signal. In addition, the disclosed method provides the PLL clock output signal to a feedback clock divider which is configured to produce the feedback clock signal for return to the phase-frequency detector.

In yet another form, there is provided a single charge-pump dual path phase locked loop (PLL) which includes a phase-frequency detector connected to receive an input reference signal and a feedback clock signal as inputs, a solitary charge pump connected to receive a phase-frequency detector error output signal from the phase-frequency detector, a second order loop filter connected to generate a voltage control signal (V_{CTL}) and an integral voltage control signal (V_{CTLi}) from the charge pump control current from the charge pump, a dual path voltage-to-current converter connected to receive the voltage control signal (V_{CTL}) and integral voltage control signal (V_{CTLi}) from the second order loop filter and configured to generate a ring oscillator current signal from a proportional control current and an integral control current, a current controlled oscillator connected to receive the ring oscillator current signal and configured to generate a PLL clock output signal, and a feedback clock divider connected to receive the PLL clock output signal and configured with a multiplication feedback integer (MFI) value to generate the feedback clock signal. As disclosed, the dual path voltage-to-current converter is configured with two separate paths having separate gains to generate the proportional control current and the integral control current. In selected embodiments, the dual path voltage-to-current converter may include a first current branch connected to receive the integral voltage control signal (V_{CTLi}) and configured with a first integral gain value to generate a first integral current control signal; a second current branch connected to receive the integral voltage control signal (V_{CTLi}) and configured with a second proportional gain value to generate a integral current control signal; and a third current branch connected to receive the voltage control signal (V_{CTL}) and configured with the second proportional gain value to generate a first current control signal; where the second current branch is connected to be mirrored in the third current branch to subtract the integral current control signal from the first current control signal, thereby generating a first proportional control signal that is combined with the first integral current control signal to generate the ring oscillator control signal.

One or more embodiments of the present disclosure may include features recited in the following numbered clauses:
1. A phase-locked loop (PLL), comprising: a phase-frequency detector (PFD) connected to receive an input reference signal and a feedback clock signal as inputs and configured to produce a PFD error output signal; a single charge pump connected to receive the PFD error output signal as an input and configured to produce a charge pump control current; a loop filter connected to receive the charge pump control current and configured to generate a voltage control signal (VCTL) and an integral voltage control signal (VCTLi); a dual path voltage-to-current converter circuit that is connected to receive the voltage control signal (VCTL) and the integral voltage control signal (VCTLi), and that is configured with two separate paths having separate gains to generate a proportional control current and an integral control current that are combined to generate a ring oscillator control signal; a current controlled oscillator which is connected to receive the ring oscillator control signal and configured to produce a PLL clock output signal; and a feedback clock divider connected to receive the PLL clock output signal as an input and configured to produce the feedback clock signal for return to the phase-frequency detector.
2. The phase-locked loop of clause 1, where the loop filter comprises a series-connected resistor Rs and capacitor Cs, where the loop filter is connected and configured to generate the voltage control signal (VCTL) from one end of the resistor Rs and to generate the integral voltage control signal (VCTLi) from another end of the resistor Rs.
3. The phase-locked loop of clause 1, where the dual path voltage-to-current converter circuit comprises: a proportional current path having a first gain value for generating a proportional control current, an integral current path having a second, different gain value for generating an integral control current, and an addition circuit for summing the proportional control current and integral control current to generate the ring oscillator control signal.
4. The phase-locked loop of clause 3, where the proportional current path comprises: a first voltage-to-current converter having a proportional transconductance gain value connected to convert the voltage control signal (VCTL) to a first current control signal (ICTL); a second voltage-to-current converter having the proportional transconductance gain value connected to convert the integral voltage control signal (VCTLi) to a first integral current control signal (ICTLi); and a subtraction circuit connected to generate the proportional control current by subtracting the first integral current control signal (ICTLi) from the current control signal (ICTL).
5. The phase-locked loop of clause 4, where the first and second voltage-to-current converters are formed with FET devices having a first multiple Np of a unit size.
6. The phase-locked loop of clause 5, where the integral current path comprises a third voltage-to-current converter having an integral transconductance gain value connected to convert the integral voltage control signal (VCTLi) to the integral current control current.
7. The phase-locked loop of clause 6, where the third voltage-to-current converter is formed with FET devices having a second multiple Ni of a unit size, where Ni ≠ Np.
8. The phase-locked loop of clause 1, where the dual path voltage-to-current converter circuit comprises: a first current branch connected to receive the integral voltage control signal (VCTLi) and configured with a first integral gain value to generate a first integral current control signal; a second current branch connected to receive the integral voltage control signal (VCTLi) and configured with a second proportional gain value to generate a integral current control signal; and a third current branch connected to receive the voltage control signal (VCTL) and configured with the second proportional gain value to generate a first current control signal; where the second current branch is connected to be mirrored in the third current branch to subtract the integral current control signal from the first current control signal, thereby generating a first proportional control signal that is combined with the first integral current control signal to generate the ring oscillator control signal.
9. A method of operating a single charge-pump dual path phase locked loop (PLL) circuit, comprising: generating a phase-frequency error measure at a phase-frequency detector by detecting a phase difference between an input reference signal and a feedback clock signal; generating a charge pump control current at a single charge-pump in response to the phase-frequency error measure; filtering the charge pump control current with a loop filter to produce a voltage control signal (VCTL) and an integral voltage control signal (VCTLi); generating a proportional control current and an integral control current at a dual path voltage-to-current converter circuit in response to the voltage control signal (VCTL) and the integral voltage control signal (VCTLi); combining the proportional control current and the integral control current to generate a ring oscillator control signal; generating a PLL clock output signal with a current controlled oscillator in response to the ring oscillator control signal; and providing the PLL clock output signal to a feedback clock divider which is configured to produce the feedback clock signal for return to the phase-frequency detector, where the dual path voltage-to-current converter circuit is configured with two separate paths having separate gains to generate the proportional control current and the integral control current.
10. The method of clause 9, where filtering the charge pump control current comprises supplying the phase-frequency error measure to a first end of a series-connected resistor Rs and capacitor Cs which has a second end connected to ground, where the loop filter is connected and configured to generate the voltage control signal (VCTL) from one end of the resistor Rs and to generate the integral voltage control signal (VCTLi) from another end of the resistor Rs.
11. The method of clause 9, where generating the proportional control current comprises supplying the voltage control signal (VCTL) and the integral voltage control signal (VCTLi) to a proportional current path in the dual path voltage-to-current converter circuit having a first gain value for generating the proportional control current.
12. The method of clause 11, where generating the integral control current comprises supplying the integral voltage control signal (VCTLi) to an integral current path in the dual path voltage-to-current converter circuit having a second, different gain value for generating the integral control current.
13. The method of clause 12, where combining the proportional control current and the integral control current comprises supplying the proportional control current and the integral control current to an addition circuit which is configured and connected to generate the ring oscillator control signal.
14. The method of clause 11, where the proportional current path comprises: a first voltage-to-current converter having a proportional transconductance gain value connected to convert the voltage control signal (VCTL) to a first current control signal (ICTL); a second voltage-to-current converter having the proportional transconductance gain value connected to convert the integral voltage control signal (VCTLi) to a first integral current control signal (ICTLi); and a subtraction circuit connected to generate the proportional control current by subtracting the first integral current control signal (ICTLi) from the current control signal (ICTL).
15. The method of clause 14, where the first and second voltage-to-current converters are formed with FET devices having a first multiple Np of a unit size.
16. The method of clause 12, where the integral current path comprises a third voltage-to-current converter having an integral transconductance gain value connected to convert the integral voltage control signal (VCTLi) to the integral current control current.
17. The method of clause 16, where the third voltage-to-current converter is formed with FET devices having a multiple Ni of a unit size that is different from a multiple Np of the unit size used with FET devices forming the proportional current path.
18. The method of clause 9, where the dual path voltage-to-current converter circuit comprises: a first current branch connected to receive the integral voltage control signal (VCTLi) and configured with a first integral gain value to generate a first integral current control signal; a second current branch connected to receive the integral voltage control signal (VCTLi) and configured with a second proportional gain value to generate a integral current control signal; and a third current branch connected to receive the voltage control signal (VCTL) and configured with the second proportional gain value to generate a first current control signal; where the second current branch is connected to be mirrored in the third current branch to subtract the integral current control signal from the first current control signal, thereby generating a first proportional control signal that is combined with the first integral current control signal to generate the ring oscillator control signal.
19. A single charge-pump dual path phase locked loop (PLL) comprising a phase-frequency detector connected to receive an input reference signal and a feedback clock signal as inputs, a solitary charge pump connected to receive a phase-frequency detector error output signal from the phase-frequency detector, a second order loop filter connected to generate a voltage control signal (VCTL) and an integral voltage control signal (VCTLi) from the charge pump control current from the charge pump, a dual path voltage-to-current converter connected to receive the voltage control signal (VCTL) and integral voltage control signal (VCTLi) from the second order loop filter and configured to generate a ring oscillator current signal from a proportional control current and an integral control current, a current controlled oscillator connected to receive the ring oscillator current signal and configured to generate a PLL clock output signal, and a feedback clock divider connected to receive the PLL clock output signal and configured with a multiplication feedback integer (MFI) value to generate the feedback clock signal, where the dual path voltage-to-current converter is configured with two separate paths having separate gains to generate the proportional control current and the integral control current.
20. The single charge-pump dual path PLL of clause 19, where the dual path voltage-to-current converter comprises: a first current branch connected to receive the integral voltage control signal (VCTLi) and configured with a first integral gain value to generate a first integral current control signal; a second current branch connected to receive the integral voltage control signal (VCTLi) and configured with a second proportional gain value to generate a integral current control signal; and a third current branch connected to receive the voltage control signal (VCTL) and configured with the second proportional gain value to generate a first current control signal; where the second current branch is connected to be mirrored in the third current branch to subtract the integral current control signal from the first current control signal, thereby generating a first proportional control signal that is combined with the first integral current control signal to generate the ring oscillator control signal.

Although the described exemplary embodiments disclosed herein are directed to various PLL circuit devices, designs, and methods of operation, the present disclosure is not necessarily limited to the example embodiments which illustrate inventive aspects of the present invention that are applicable to a wide variety of PLL circuit devices, designs, and methods of operation. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A phase-locked loop (PLL), comprising:
a phase-frequency detector (PFD) connected to receive an input reference signal and a feedback clock signal as inputs and configured to produce a PFD error output signal;
a single charge pump connected to receive the PFD error output signal as an input and configured to produce a charge pump control current;
a loop filter connected to receive the charge pump control current and configured to generate a voltage control signal (V_{CTL}) and an integral voltage control signal (V_{CTLi});
a dual path voltage-to-current converter circuit that is connected to receive the voltage control signal (V_{CTL}) and the integral voltage control signal (V_{CTLi}), and that is configured with two separate paths having separate gains to generate a proportional control current and an integral control current that are combined to generate a ring oscillator control signal;
a current controlled oscillator which is connected to receive the ring oscillator control signal and configured to produce a PLL clock output signal; and
a feedback clock divider connected to receive the PLL clock output signal as an input and configured to produce the feedback clock signal for return to the phase-frequency detector.

2. The phase-locked loop of claim 1, where the loop filter comprises a series-connected resistor Rs and capacitor Cs, where the loop filter is connected and configured to generate the voltage control signal (V_{CTL}) from one end of the resistor Rs and to generate the integral voltage control signal (V_{CTLi}) from another end of the resistor Rs.

3. The phase-locked loop of claim 1 or 2, where the dual path voltage-to-current converter circuit comprises:
a proportional current path having a first gain value for generating a proportional control current,
an integral current path having a second, different gain value for generating an integral control current, and
an addition circuit for summing the proportional control current and integral control current to generate the ring oscillator control signal.

4. The phase-locked loop of claim 3, where the proportional current path comprises:
a first voltage-to-current converter having a proportional transconductance gain value connected to convert the voltage control signal (V_{CTL}) to a first current control signal (I_{CTL});
a second voltage-to-current converter having the proportional transconductance gain value connected to convert the integral voltage control signal (V_{CTLi}) to a first integral current control signal (I_{CTLi}); and
a subtraction circuit connected to generate the proportional control current by subtracting the first integral current control signal (I_{CTLi}) from the current control signal (I_{CTL}).

5. The phase-locked loop of claim 4, where the first and second voltage-to-current converters are formed with FET devices having a first multiple Np of a unit size.

6. The phase-locked loop of claim 4 or 5, where the integral current path comprises a third voltage-to-current converter having an integral transconductance gain value connected to convert the integral voltage control signal (V_{CTLi}) to the integral current control current.

7. The phase-locked loop of claim 6, where the third voltage-to-current converter is formed with FET devices having a second multiple Ni of a unit size, where Ni ≠ Np.

8. The phase-locked loop of any of claims 1 to 7, where the dual path voltage-to-current converter circuit comprises:
a first current branch connected to receive the integral voltage control signal (V_{CTLi}) and configured with a first integral gain value to generate a first integral current control signal;
a second current branch connected to receive the integral voltage control signal (V_{CTLi}) and configured with a second proportional gain value to generate a integral current control signal; and
a third current branch connected to receive the voltage control signal (V_{CTL}) and configured with the second proportional gain value to generate a first current control signal;
where the second current branch is connected to be mirrored in the third current branch to subtract the integral current control signal from the first current control signal, thereby generating a first proportional control signal that is combined with the first integral current control signal to generate the ring oscillator control signal.

9. A method of operating a single charge-pump dual path phase locked loop (PLL) circuit, comprising:
generating a phase-frequency error measure at a phase-frequency detector by detecting a phase difference between an input reference signal and a feedback clock signal;
generating a charge pump control current at a single charge-pump in response to the phase-frequency error measure;
filtering the charge pump control current with a loop filter to produce a voltage control signal (V_{CTL}) and an integral voltage control signal (V_{CTLi});
generating a proportional control current and an integral control current at a dual path voltage-to-current converter circuit in response to the voltage control signal (V_{CTL}) and the integral voltage control signal (V_{CTLi});
combining the proportional control current and the integral control current to generate a ring oscillator control signal;
generating a PLL clock output signal with a current controlled oscillator in response to the ring oscillator control signal; and
providing the PLL clock output signal to a feedback clock divider which is configured to produce the feedback clock signal for return to the phase-frequency detector,
where the dual path voltage-to-current converter circuit is configured with two separate paths having separate gains to generate the proportional control current and the integral control current.

10. The method of claim 9, where filtering the charge pump control current comprises supplying the phase-frequency error measure to a first end of a series-connected resistor Rs and capacitor Cs which has a second end connected to ground, where the loop filter is connected and configured to generate the voltage control signal (V_{CTL}) from one end of the resistor Rs and to generate the integral voltage control signal (V_{CTLi}) from another end of the resistor Rs.

11. The method of claim 9 or 10, where generating the proportional control current comprises supplying the voltage control signal (V_{CTL}) and the integral voltage control signal (V_{CTLi}) to a proportional current path in the dual path voltage-to-current converter circuit having a first gain value for generating the proportional control current.

12. The method of any of claims 9 to 11, where generating the integral control current comprises supplying the integral voltage control signal (V_{CTLi}) to an integral current path in the dual path voltage-to-current converter circuit having a second, different gain value for generating the integral control current.

13. The method of claim 12, where combining the proportional control current and the integral control current comprises supplying the proportional control current and the integral control current to an addition circuit which is configured and connected to generate the ring oscillator control signal.

14. The method of claim 11, where the proportional current path comprises:
a first voltage-to-current converter having a proportional transconductance gain value connected to convert the voltage control signal (V_{CTL}) to a first current control signal (I_{CTL});
a second voltage-to-current converter having the proportional transconductance gain value connected to convert the integral voltage control signal (V_{CTLi}) to a first integral current control signal (I_{CTLi}); and
a subtraction circuit connected to generate the proportional control current by subtracting the first integral current control signal (I_{CTLi}) from the current control signal (I_{CTL}).

15. The method of claim 14, where the first and second voltage-to-current converters are formed with FET devices having a first multiple Np of a unit size.
